(19) Europäisches Patentamt
European Patent Office
Office européen des brevets

(11) **EP 0 903 863 A1**

(12) **EUROPEAN PATENT APPLICATION**

(43) Date of publication:
24.03.1999 Bulletin 1999/12

(51) Int. Cl.$^6$: **H03M 3/02**

(21) Application number: 97116354.8

(22) Date of filing: 19.09.1997

(84) Designated Contracting States:
AT BE CH DE DK ES FI FR GB GR IE IT LI LU MC NL PT SE
Designated Extension States:
LT LV SI

(71) Applicant: **MOTOROLA, INC.**
**Schaumburg, IL 60196 (US)**

(72) Inventors:
• **Koifman, Vladimir**
  **Rishon-Lezion (IL)**

• **Zarubinski, Michael**
  **Jerusalem (IL)**
• **Afek, Yachin**
  **Kfar Saba (IL)**

(74) Representative:
**Richardt, Markus Albert**
**Motorola GmbH,**
**Hagenauerstrasse 47**
**65203 Wiesbaden (DE)**

(54) **One-bit analog-to-digital converter**

(57) A sigma-delta ADC modulator operating in non-overlapping precharge phase and resolve phase has an input circuit (72, 122) for receiving an input signal, an integrator circuit (74, 124), a comparator circuit (76, 126) coupled to the integrator circuit for providing an output signal, and a feedback circuit (78, 128) for feeding the output signal back to the integrator circuit. The integrator circuit includes an integrating capacitor (84, 134), and an additional integrating capacitor (86, 136) switchable coupled to the integrating capacitor via an integrator switch (88,138). The additional integrating capacitor is discoupled from the integrating capacitor during the precharge phase, and coupled to the integrating capacitor during the resolve phase. This allows to "predict" sign changes of the comparator signal expected in the resolve phase.

FIG. 4

## Description

## FIELD OF THE INVENTION

The present invention relates to analog-to-digital converters (ADCs) and, more particularly, to sigma-delta analog-to-digital converters.

## BACKGROUND OF THE INVENTION

Sigma-delta ADCs have recently come into wide spread use in the development of suitable process technology and the increase in digital audio and other applications. Sigma-delta converters utilize oversampling techniques (i.e., sampling rates greater than the Nyquist rate) to achieve high signal-to-noise ratios. Such converters also exhibit excellent linearity. Additionally, sigma-delta converters are relatively straightforward and inexpensive due to their simplicity.

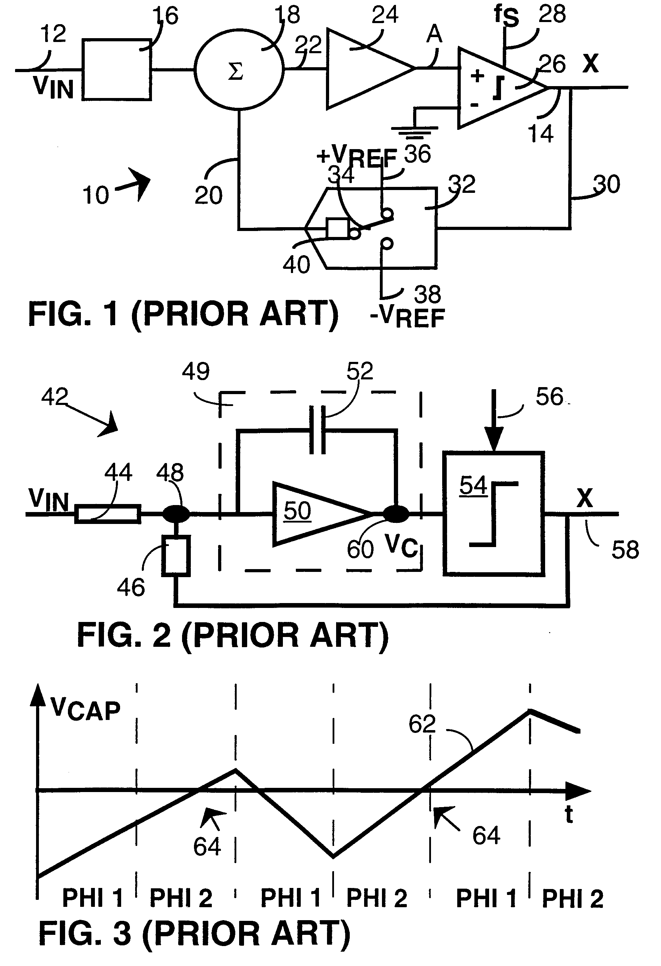

A sigma-delta ADC converts an analog input voltage to digital output samples at a predetermined rate. Conventional, first order sigma-delta ADC modulator 10 is shown in block diagram form in FIG. 1. ADC modulator 10 converts an input voltage signal $V_{in}$, received on line 12, into one-bit data stream X at a rate determined by the sampling frequency $Kf_S$. One-bit data stream X is provided on output line 14.

Modulator 10 includes input circuit 16 which samples input signal $V_{IN}$ and provides the sampled input signal to a summing circuit 18. Summing circuit 18 subtracts the feedback signal (described below), received on line 20 from the sampled input line and provides the output signal difference on line 22 to an integrator 24. Integrator 24 conveniently "integrates" the output signal difference from summing circuit 22 and provides output signal A to a clocked, latched comparator 26. Summing circuit 18 can generally be considered as an input section of the integrator. Comparator 26 conveniently is clocked at a rate $Kf_S$ by a clock signal applied to line 28. For each clock pulse, comparator 26 "compares" signal A to ground and provides a one bit output. The sequence of outputs for a sequence of clock pulses form one bit data stream output X of the modulator on output line 14. Thus, comparator 26 is effectively a one-bit ADC.

Data stream X is also provided on feedback line 30 to feedback circuit 32, which includes a one bit digital-to-analog converter (DAC) (not shown). The stream X controls a switch 34 within the feedback circuit 32 such that either a positive feedback reference voltage $+V_{REF}$ received on line 36, or a negative feedback reference voltage $-V_{REF}$ received on line 38, will be applied, for each bit in stream X, via feedback line 30, to circuitry 40, which generates and supplies a corresponding feedback signal to summing circuit 18. This switching operation of feedback circuit 32 of modulator 10 is conventional for a closed-loop circuit and should be readily understood by those skilled in the art.

The above description of the modulator, in which a signal input voltage is sampled (with respect to ground) assumes integrator 24 based on use of a signal-ended op amp. As will be understood by those skilled in the art, however, the integrator may include a differential amplifier for which positive and negative input voltages are separately sampled.

A very simple and inexpensive realization of such a prior art ADC is shown schematically in FIG. 2. In modulator 42, the input circuit is substantially reduced to input resistor 44, and the feedback circuit is substantially reduced to feedback resistor 46. Input resistor 44 and feedback resistor 46 are coupled to node 48 which substantially forms the summing circuit. Integrator circuit 49 is substantially reduced to op amp 50 and integrating capacitor 52, both of which are coupled to node 48 on the input side and to comparator 54 on the output side. Comparator 54 has clock input 56 and output 58 which outputs the output signal X. It is known in the art to choose input resistor 44, feedback resistor 46 and integrating capacitor 52 so that the voltage level of the input signal $V_{IN}$ and the output level X are adapted so that modulator 42 substantially acts like modulator 10 of FIG. 1. FIG. 2 further shows point 60, where integrator output voltage $V_C$ applies.

FIG. 3 shows schematically graph 62 of integrator output voltage $V_C$, taken at point 60 of FIG. 2, depending on time t. FIG. 3 will be described with respect to the elements of FIG. 2 and their reference numbers. Modulator 42 is clocked, and each clock cycle consists of precharge phase PHI 1 and resolve phase PHI 2. Comparator 54 needs time to resolve its input and switch its output accordingly. To accomplish this, comparator 54 samples the integrator output during precharge phase PHI 1 and resolves the sampled signal during resolve phase PHI 2. The shorter resolve phase PHI 2 is chosen, the more power is consumed by comparator 54. The shorter phase PHI 2, the shorter is the delay in the sigma-delta loop. The shorter the delay in sigma-delta loop, the higher is the accuracy of this loop. So the input signal would be represented more accurately at the output. Thus, the lengths of precharge phase PHI 1 and resolve phase PHI 2 are a compromise between accuracy and power consumption. Precharge phase PHI 1 and resolve phase PHI 2 are shown in FIG. 3 of the same duration, but different lengths in time can be chosen.

A major inaccuracy occurs in the prior sigma-delta ADC modulator 42, if the input voltage of comparator 54 changes its sign, indicated with 64, close before the end of resolve phase PHI 2. Then, comparator 54 has no time to resolve the correct sign of its comparator input voltage and outputs a wrong signal. This error reduces the total accuracy of ADC modulator 42 significantly.

There is a need for sigma-delta ADC modulators, that have a better total accuracy.

## BRIEF DESCRIPTION OF THE DRAWINGS

Fig. 1 is a schematic diagram of a sigma-delta ADC modulator according to the prior art;

Fig. 2 is a schematic diagram of a very simple sigma-delta ADC modulator according to the prior art;

Fig. 3 is a schematic graph of the comparator input voltage of the sigma-delta ADC modulator of FIG. 2; Fig. 4 is a simplified schematic diagram of a sigma-delta ADC modulator according to a preferred embodiment of the present invention;

Fig. 5 is a schematic graph of the comparator input voltage of the sigma-delta ADC modulator of FIG. 4;

Fig. 6 is a simplified schematic diagram of a sigma-delta ADC modulator according to another embodiment of the present invention.

## DETAILED DESCRIPTION OF THE PREFERRED EMBODIMENT

It is an advantage of the present invention to provide a sigma-delta ADC modulator, where the comparator has more time to estimate the correct sign of the comparator input voltage. It is another advantage of the present invention to provide a sigma-delta ADC modulator with less power consumption or an improved accuracy compared to prior art sigma-delta ADC modulators.

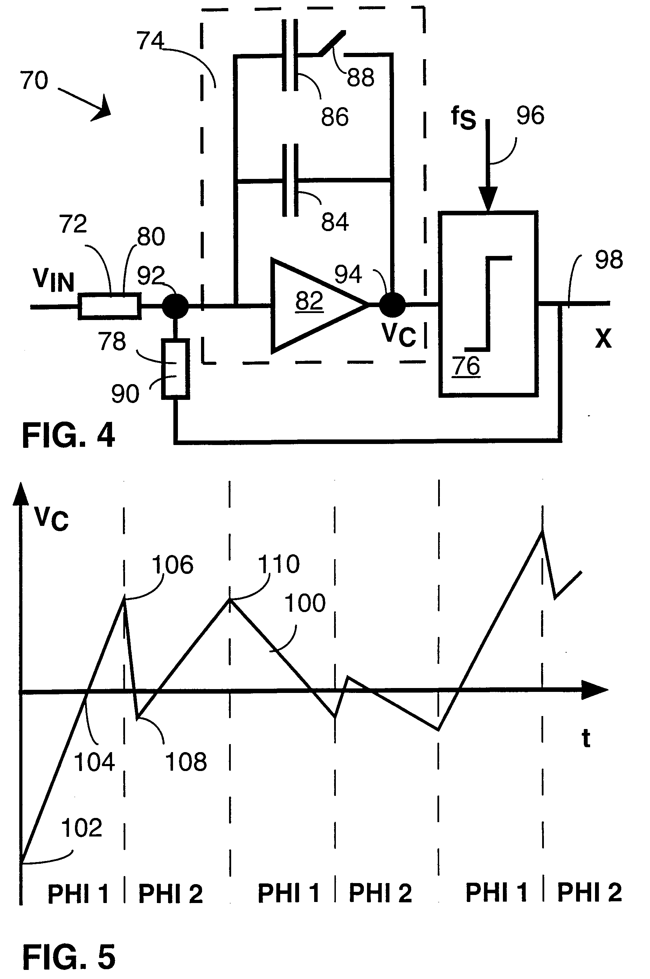

FIG. 4 shows a simplified schematic diagram of sigma-delta ADC modulator 70 according to a preferred embodiment of the present invention. Sigma-delta ADC modulator 70 has input circuit 72 for receiving the input signal $V_{IN}$, integrator circuit 74, comparator circuit 76 coupled to integrator circuit 74 for providing output signal X, and feedback circuit 78 for feeding output signal X back to integrator circuit 74. Input circuit 72 comprises input resistor 80. Integrator circuit 74 comprises op amp 82, integrating capacitor 84, additional integrating capacitor 86 and integrator switch 88. Feedback circuit 78 comprises feedback resistor 90. Input resistor 80, feedback resistor 90 and op amp 82 are coupled to node 92. The output of op amp 82 is coupled to the input of comparator circuit 76 via point 94 which serves as a measurement point for integrator output voltage $V_C$. Integrating capacitor 84 is also coupled to the input and output of op amp 82, and additional integrating capacitor 86 is coupled directly to the input of op amp 82, and via integrator switch 88 to the output of op amp 82. Op amp 82 is shown as a single input op amp which can be understood as an amplifier that amplifies with respect to ground level.

Comparator circuit 76 compares its input voltage with respect to the ground level in every clock cycle provided by clock frequency $f_S$ at clock input 96. Comparator circuit 76 outputs at 98 output signal X, which is a pulse train of binary signals with voltage levels symmetric to ground. The average per time unit of the output voltage level with respect to the ground level represents analog input voltage $V_{IN}$ with respect to the ground level.

ADC modulator 70 operates as follows. Input circuit 72 and feedback circuit 78 provide a common voltage signal at node 92 and therefore at the input of op amp 82. Each clock cycle of clock frequency $f_S$ comprises first and second non-overlapping phases PHI 1 and PHI 2, respectively. During phase PHI 1 integrator switch 88 is open and the op amp input voltage only charges integrating capacitor 84. One can also understand that op amp 82 keeps its input at virtual ground potential. So the right-hand plate of capacitor 84 changes its potential, while the left-hand one is at virtual ground voltage.

During phase PHI 2 integrator switch 88 is closed and integrating capacitor 84 and additional integrating capacitor 86 are coupled to the input as well as to the output of op amp 82. When integrator switch 88 is closed, the charges of integrating capacitor 84 and additional integrating capacitor 86 are combined and adjust to the same voltage level on those capacitors. During phase PHI 2, the input signal $V_{IN}$, processed by input circuit 72, and the output signal X, processed by feedback circuit 78 modify the voltage of those coupled capacitors 84, 86. Op amp 82 tends to provide an output voltage that adjusts its input voltage to ground level. Comparator circuit 76 compares the output of op amp 82 with respect to ground level. This comparator precharges during phase PHI 1 and performs the compare during phase PHI 2 of each clock cycle of clock frequency $f_S$. At the end of phase PHI 2 comparator circuit 76 outputs as output signal X a voltage impulse. Output signal X can only assume two voltages, because it is a binary signal, and its average per time unit represents ADC modulator input voltage $V_{IN}$.

FIG. 5 shows a graph of the comparator circuit input voltage $V_C$ taken at point 94 as a function of time t, over several clock cycles. Graph 100 starts at the begin of phase PHI 1, where integrator switch 88 opens and at this time integrator capacitor 84 and additional integrator capacitor 86 have the same start voltage 102. In FIG. 5, it is assumed that both phases PHI 1 and PHI 2 are of the same duration and integrating capacitor 84 and additional integrating capacitor 86 are of the same capacity. Then, the combined capacities of phase PHI 1 is one half of that of phase PHI 2. The combined capacity is a capacity according to the prior art. Thus, in phase PHI 1, because of the smaller capacity the slope of graph 100 during phase PHI 1 is much steeper than it would be according to the prior art. Because of the small capacity and the steep slope, there is a sign change in phase PHI 1, indicated as 104.

According to the prior art this sign change would happen in phase PHI 2 in a prior art ADC modulator of the type shown in FIG. 2. According to the invention, at the begin of phase PHI 2 comparator circuit 76 "sees in advance" a voltage close to the correct voltage and is able to adjust the correct sign of output signal X. At the begin of phase PHI 2 integrator switch 88 is closed and integrating capacitor 84 has a voltage indicated by 106 and in additional integrating capacitor 86 still has start voltage 102. After the exchange of charges between integrating capacitor 84 and additional integrating capacitor 86 these have combined voltage 108. Because of the higher combined capacity the slope of graph 100 during phase PHI 2 is smaller than during phase PHI 1. At the end of phase PHI 2 the end of a clock cycle, the voltage reaches end level 110 which is close to the "predicted" level indicated by 106.

Therefore, because of the "voltage prediction" according to the invention, the comparator samples its input at the end of PHI 1 and has more time to estimate the correct sign. This allows a longer resolving phase PHI 2 with less power consumption or an improved accuracy in the case of a sign change of the comparator input voltage and therefore an improved overall accuracy compared to prior art sigma-delta ADC modulators.

Sigma-delta ADC modulator 70 operates in first and second non-overlapping clock phases and integrator circuit 74 has an integrating coefficient that equals $k_1$ in the first clock phase and equals $k_2$ in the second clock phase with $k_2 > k_1$. Preferred is $k_2 = 2 k_1$.

A method for one-bit sigma-delta A-D conversion performed on a sigma-delta ADC modulator having an input circuit, an integrator circuit having an integrating capacitor and an additional integrating capacitor switchable couplable in parallel to the integrating capacitor, coupled to the input circuit, a comparator circuit coupled to the integrator circuit, and a feedback circuit, comprises of the steps: receiving an input signal;

charging the integrating capacitor and not charging the additional integrating capacitor by an integrator input signal during a first of first and second non-overlapping time intervals;
charging the integrating capacitor and charging the additional integrating capacitor by the integrator input signal during the second time interval;
providing an output signal; and
feeding the output signal back to the integrator circuit. Some of these steps can be performed simultaneously.

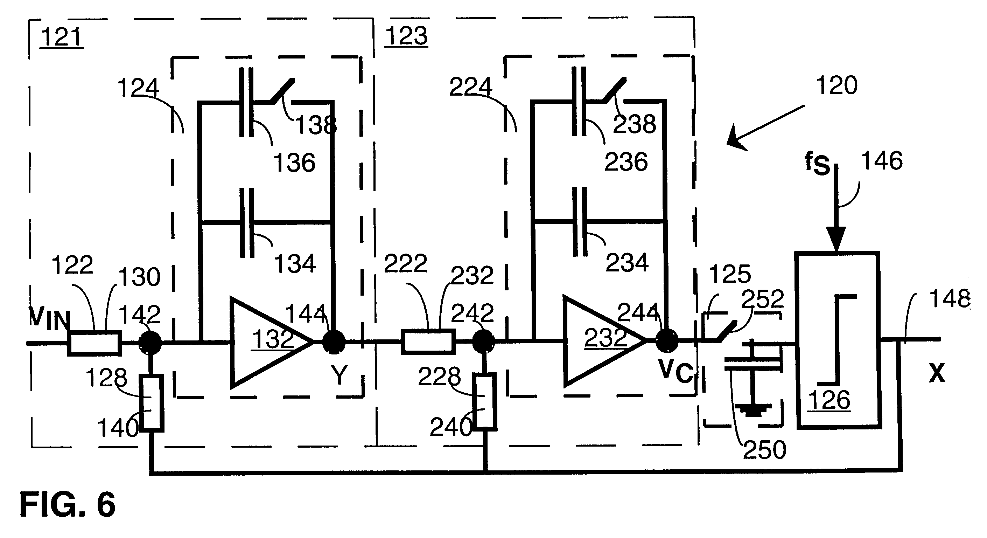

FIG. 6 shows a simplified schematic diagram of sigma-delta ADC modulator 120 according to still another embodiment of the present invention. Sigma-delta ADC modulator 120 has some similar elements as modulator 70 of Fig. 4 but has two principal differences. First, modulator 120 is a second order ADC modulator having first integrating stage 121 and second integrating stage 123. Second, modulator 120 has hold circuit 125.

First integrating stage 121 has first input circuit 122 for receiving input signal $V_{IN}$, first integrator circuit 124 for providing intermediate signal Y, and first feedback circuit 128 for feeding modulator output signal X back to first integrator circuit 124. First input circuit 122 comprises first input resistor 130. First integrator circuit 124 comprises first op amp 132, first integrating capacitor 134, first additional integrating capacitor 136 and first integrator switch 138. First feedback circuit 128 comprises first feedback resistor 140. First input resistor 130, first feedback resistor 140 and first op amp 132 are coupled to first node 142. The output of first op amp 132 is coupled to the input of first comparator circuit 128 via first point 144 which serves as a voltage measurement point for intermediate signal Y. First integrating capacitor 134 is also coupled to the input and output of first op amp 132, and first additional integrating capacitor 136 is coupled directly to the input of first op amp 132, and via first integrator switch 138 to the output of first op amp 132. First op amp 132 is shown as a single input op amp which can be understood as an amplifier that amplifies with respect to ground level.

Second integrating stage 123 has second input circuit 222 for receiving intermediate signal Y, second integrator circuit 224 for providing integrator output voltage $V_C$, and second feedback circuit 228 for feeding modulator output signal X back to second integrator circuit 224. Second input circuit 222 comprises input resistor 230. Second integrator circuit 224 comprises second op amp 232, second integrating capacitor 234, second additional integrating capacitor 236 and second integrator switch 238. Second feedback circuit 228 comprises second feedback resistor 240. Second input resistor 230, second feedback resistor 240 and second op amp 232 are coupled to second node 242. The output of second op amp 232 is coupled to the input of second comparator circuit 228 via second point 244 which serves as a voltage measurement point for integrator output voltage $V_C$. Second integrating capacitor 234 is also coupled to the input and output of second op amp 232, and second additional integrating capacitor 236 is coupled directly to the input of second op amp 232, and via second integrator switch 238 to the output of second op amp 232. Second op amp 232 is shown as a single input op amp which can be understood as an amplifier that amplifies with respect to ground level.

Second order modulators are used to increase sigma-delta loop accuracy, because the error signal is double integrated. Sigma-delta ADC modulator 120 allows to use first input resistor 130 and first feedback resistor 140 as current sources.

Hold circuit 125 comprises of hold capacitor 250 and hold switch 252. Hold capacitor 250 is coupled to the input of comparator circuit 126 and is grounded. Hold switch 252 is between the output of second integrating stage 123 and the input of comparator circuit 126.

ADC modulator 120 operates similar to modulator 70 of FIG. 4 but with the following modifications. Both integrating stages 121, 123 act together as a unit (not shown) that receives input signal $V_{IN}$ and outputs integrator output signal $V_C$. Each clock cycle of clock frequency $f_S$ comprises first and second non-overlapping phases PHI 1 and PHI 2, respectively. During phase PHI 1 first and second integrator switches 138, 238, respectively, are open and the op amp input voltage only charges integrating capacitor 84. During phase PHI 1, hold switch 252 is closed and hold capacitor 250 is charged to the voltage level of the integrator output signal $V_C$.

During phase PHI 2 first and second integrator switches 138, 238, respectively, are closed and first and second integrating capacitors 134, 234 and additional integrating capacitors 136, 236, respectively, are coupled to the input as well as to the output of their respective op amps 132, 232. When first and second integrator switches 138, 238, respectively, are closed, the charges of the respective first and second integrating capacitors 134, 234, respectively, and their additional integrating capacitors 136, 236, respectively, are combined and adjust to the same voltage level on those capacitors. During phase PHI 2, hold switch 252 is open and hold capacitor 250 holds its voltage level during phase PHI 2 to provide it to comparator circuit 76.

During phase PHI 2, Comparator circuit 126 compares the voltage level of hold capacitor 250 with respect to ground level. This comparator pre-charges during phase PHI 1 and performs the compare during phase PHI 2 of each clock cycle of clock frequency $f_S$. At the end of phase PHI 2 comparator circuit 126 outputs as output signal X a voltage impulse. Output signal X can only assume two voltages, because it is a binary signal, but its average per time unit represents ADC modulator input voltage $V_{IN}$.

Comparator circuit 126 compares its input voltage, i.e. integrator output voltage $V_C$, with respect to the ground level in every clock cycle provided by clock frequency $f_S$ at clock input 146. Comparator circuit 126 outputs at 148 output signal X, which is a pulse train of binary signals with voltage levels symmetric to ground. The average per time unit of the output voltage level with respect to the ground level represents analog input voltage $V_{IN}$ with respect to the ground level.

Based on the description herein, those skilled in the art will know that using the op-amp is optional. An op-amp is convenient for explanation purposes. Further, one can use just current sources instead of input and feedback resistors and capacitors as an integrating element. Also, those skilled in the art will know that switches can be realized with a variety of electronic elements. And those skilled in the art will know that phases PHI 1 and PHI 2 of different duration can be chosen, and that different capacitances of integrating capacitor and additional integrating capacitor can be chosen.

In the foregoing detailed description of the preferred embodiment, reference is made to the accompanying drawings which form a part hereof, and in which are shown by way of illustration specific embodiments in which the invention may be practiced. These embodiments have been described in sufficient detail to enable those skilled in the art to practice the invention, and it is to be understood that other embodiments may be utilized and that logical, mechanical and electrical changes may be made without departing from the spirit and scope of the present invention. The foregoing detailed description is, therefore, not to be taken in a limiting sense, and the scope of the present inventions is defined only by the appended claims.

**REFERENCE NUMBERS**

    sigma-delta ADC modulator 10
    line 12
    output line 14
    input circuit 16
    summing circuit 18
    line 20
    line 22
    integrator 24
    comparator 26
    line 28
    feedback line 30
    feedback circuit 32
    switch 34
    line 36
    line 38
    circuitry 40
    modulator 42
    input resistor 44
    feedback resistor 46
    node 48
    Integrator circuit 49
    op amp 50
    integrating capacitor 52
    comparator 54
    clock input 56
    output 58
    point 60
    graph 62
    changes its sign, indicated with 64
    Sigma-delta ADC modulator 70
    input circuit 72
    integrator circuit 74
    comparator circuit 76
    feedback circuit 78
    input resistor 80
    op amp 82
    integrating capacitor 84
    additional integrating capacitor 86
    integrator switch 88
    feedback resistor 90
    node 92

point 94

clock input 96

outputs at 98 output signal X

Graph 100

start voltage 102

change in phase P1, indicated as 104.

"predicted" level indicated by 106

combined voltage 108

end level 10

**122-148 = first stage, 222-248 =second stage,**
**==72-98 _ + 50 / + 150**

Sigma-delta ADC modulator 120

first integrating stage 121

second integrating stage 123

hold circuit 125

hold capacitor 250

hold switch 252

## Claims

1. A sigma-delta ADC modulator (70, 120) having an input circuit (72, 122) for receiving an input signal ($V_{IN}$), an integrator circuit (74, 124) coupled to the input circuit, a comparator circuit (76, 126) coupled to the integrator circuit for providing an output signal, and a feedback circuit (78, 128) for feeding the output signal back to the integrator circuit, wherein the integrator circuit includes an integrating capacitor (84, 134) and an additional integrating capacitor (86, 136) switchable coupled to the integrating capacitor via an integrator switch (88,138).

2. The sigma-delta ADC modulator of claim 1, wherein the integrator circuit (74, 124) includes an op amp (82,132) having an op amp input lead and an op amp output lead, the integrating capacitor (84, 134) being coupled to the op amp input lead and the op amp output lead, and the additional integrating capacitor (86, 136) being switchable coupled to the op amp input lead and the op amp output lead via the integrator switch (88,138).

3. The sigma-delta ADC modulator of claim 1, wherein the input circuit (72, 122) comprises a input resistor (80, 130) and the feedback circuit (78, 128) comprises a feedback resistor (90, 140).

4. The sigma-delta ADC modulator of claim 1, wherein the integrating capacitor (84, 134) and the additional integrating capacitor (86, 136) are of the same capacitance.

5. The sigma-delta ADC modulator of claim 1, further having a second order circuit coupled to the integrator circuit comprising a second order input circuit (222), a second order integrator circuit (224), and a second order feedback circuit (228) for feeding the output signal back to the second order integrator circuit, wherein the second order integrator circuit includes a second order integrating capacitor (234) and a second order additional integrating capacitor (236) switchable coupled to the second order integrating capacitor via a second order integrator switch (238).

6. The sigma-delta ADC modulator of claim 5, wherein the second order integrator circuit (224) includes a second order op amp (232) having a second order op amp input lead and a second order op amp output lead, the second order integrating capacitor (234) being coupled to the second order op amp input lead and the second order op amp output lead, and the second order additional integrating capacitor (236) being switchable coupled to the second order op amp input lead and the second order op amp output lead via a second order integrator switch (238).

7. The sigma-delta ADC modulator of claim 1, further having a hold circuit (125) for holding the comparator input level comprising a hold switch (252) between the integrator circuit and the comparator circuit and a hold capacitor (250) coupled to the input of the comparator circuit (126).

8. A sigma-delta ADC modulator (70, 120) having a input circuit (72, 122) for receiving the input signal ($V_{IN}$), a integrator circuit (74, 124) coupled to the input circuit, a comparator circuit coupled to the integrator circuit for providing an output signal, and a feedback circuit (76, 126) for feeding the output signal back to the integrator circuit, wherein the sigma-delta ADC modulator operates in first and second non-overlapping clock phases and the integrator circuit has a integrating coefficient that equals $k_1$ in the first clock phase and equals $k_2$ in the second clock phase with $k_2 > k_1$.

9. The sigma-delta ADC modulator of claim 8, wherein $k_2 = 2 k_1$.

10. A method for one-bit sigma-delta A-D conversion performed on a sigma-delta ADC modulator having an input circuit, an integrator circuit having an integrating capacitor and an additional integrating capacitor switchable couplable in parallel to the integrating capacitor, coupled to the input circuit, a comparator circuit coupled to the integrator circuit, and a feedback circuit, comprising the steps of:
receiving a input signal;

    charging the integrating capacitor and not charging the additional integrating capacitor by a integrator input signal during a first of first and second non-overlapping time intervals;
charging the integrating capacitor and charging the additional integrating capacitor by the integrator input signal during the second time interval;

providing an output signal; and

feeding the output signal back to the integrator circuit.

11. The method of claim 10, performed on a second order one-bit sigma-delta ADC modulator.

**FIG. 1 (PRIOR ART)**

**FIG. 2 (PRIOR ART)**

**FIG. 3 (PRIOR ART)**

FIG. 4

FIG. 5

**FIG. 6**

**European Patent Office**

## EUROPEAN SEARCH REPORT

Application Number

EP 97 11 6354

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP 0 607 712 A (SCHLUMBERGER IND SA) * column 3, line 42 - column 4, line 30; figures 3,5 * | 1,8,10 | H03M3/02 |
| A | HARVEY B: "DELTA MODULATORS SIMPLIFY A/D CONVERSION" EDN ELECTRICAL DESIGN NEWS (FOR THE WHOLE COLLECTION USE BOCA..LI MAX), vol. 34, no. 13, 22 June 1989, pages 175-182, 184, XP000111366 * figure 4 * | 1,8,10 | |
| A | US 5 376 936 A (KERTH DONALD A ET AL) * abstract * | 1,8,10 | |

TECHNICAL FIELDS SEARCHED (Int.Cl.6)

H03M

The present search report has been drawn up for all claims

| Place of search | Date of completion of the search | Examiner |
|---|---|---|
| THE HAGUE | 5 February 1998 | Blaas, D-L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)